# EUROPEAN PATENT SPECIFICATION

(11) **EP 2 399 271 B1**
(45) Date of publication and mention of the grant of the patent: **16.01.2013**
(21) Application number: 10704835.7
(22) Date of filing: 22.02.2010
(51) Int. Cl.: H01J 37/317, H01J 37/16, H01J 37/18, H01L 21/677, H01L 21/67, H01L 21/00, B82Y 10/00

(54) **LITHOGRAPHY MACHINE AND SUBSTRATE HANDLING ARRANGEMENT**
LITHOGRAFIEMASCHINE UND SUBSTRATHANDHABUNGSANORDNUNG
MACHINE DE LITHOGRAPHIE ET AGENCEMENT DE MANIPULATION DE SUBSTRAT

(30) Priority: 22.02.2009 US 154411 P; 22.02.2009 US 154415 P; 23.12.2009 US 289407 P; 19.02.2010 US 306333 P
(43) Date of publication of application: 28.12.2011
(73) Proprietor: Mapper Lithography IP B.V., 2628 XK Delft (NL)
(72) Inventor: DE BOER, Guido, NL-4145 LN Leerdam (NL); BALTUSSEN, Sander, NL-4824 GB Breda (NL); DE JONG, Hendrik Jan, NL-2531 AA Den Haag (NL)
(74) Representative: Mooij, Maarten
(86) International application number: PCT/EP2010/052221
(87) International publication number: WO 2010/094804

(56) References cited:
- US-A- 3 365 091
- US-A1- 2002 062 166
- US-A1- 2007 144 439
- US-A1- 2007 269 296
- US-B1- 6 235 634
- US-B1- 6 573 520

## Description

### BACKGROUND OF THE INVENTION

### 1. Field of the Invention

The present invention relates to a charged particle lithography apparatus and an arrangement of such lithography apparatuses in a cluster.

### 2. Description of the Related Art

Charged particle and optical lithography machines and inspection machines are typically operated in a vacuum environment. This requires a vacuum chamber large enough to house the lithography machine or group of machines. The vacuum chamber must be sufficiently strong and airtight to support the required vacuum, while having openings for electrical, optical and power cabling to enter the chamber, for the wafer or target to be loaded into the chamber, and to permit access to machine for maintenance and operational needs. Where charged particle machines are involved, the vacuum chamber must also provide shielding to prevent external electromagnetic fields from interfering with the operation of the machine.

Prior vacuum chamber designs have suffered from various drawbacks such as excessive weight relative to throughput of the lithography machine, excessive use of floor space, absence of a door, and poor electromagnetic shielding around the openings.

### BRIEF SUMMARY OF THE INVENTION

The present invention aims to provide an improved vacuum chamber addressing the shortcomings of prior designs. According to one aspect of the invention, an arrangement comprises a plurality of charged particle lithography apparatuses, each charged particle lithography apparatus having a vacuum chamber. The arrangement further comprises a common robot for conveying wafers to the plurality of lithography apparatuses, and a wafer load unit for each charged particle lithography apparatus arranged at a front side of each respective vacuum chamber. The plurality of lithography apparatuses are arranged in a row with the front side of the lithography apparatuses facing an aisle accommodating passage of the common robot for conveying wafers to each apparatus, and the rear side of each lithography apparatus faces an access corridor, and the back wall of each vacuum chamber is provided with an access door for access to the respective lithography apparatus.

The plurality of lithography apparatuses may be arranged in two rows having a central common aisle. The two rows of lithography apparatuses may be arranged opposite each other with the central common aisle between them, and the two rows of lithography apparatuses may be stacked vertically, both rows facing the central common aisle. The plurality of lithography apparatuses may also be arranged in a plurality of rows having a central common aisle, wherein at least two of the rows of lithography apparatuses are arranged opposite each other with the central common aisle between them, and at least two of the rows of lithography apparatuses are stacked vertically, both rows facing the central common aisle.

Each lithography apparatus may be provided with a load lock unit at its front wall. A stage actuator may be provided for each charged particle lithography apparatus is disposed at a front side of each respective lithography apparatus. The stage actuator units may include actuation members or rods for moving a stage inside each respective chamber. The load lock unit may be arranged above the stage actuator of each respective lithography apparatus.

The common robot may comprise at least two robot units, and the arrangement may further comprise a robot storage unit, which may be arranged at an end of a row of lithography apparatuses, adjacent to the aisle. One or more of the lithography apparatuses in a row may be arranged stacked vertically, in two or more layers. Each lithography apparatus may be provided with an individual support from a floor, or each layer of lithography apparatuses may be provided with a separate support to a floor.

According to another aspect, the arrangement may be considered as a single charged particle lithography machine, comprising a plurality of lithography processing units each arranged in a vacuum chamber (400), the machine further comprising a common robot (305) for conveying wafers to the plurality of processing units, and a wafer load unit (303) for each processing unit arranged at a front side of each respective vacuum chamber (400). The plurality of processing units are arranged in a row with the front side of the processing unit facing an aisle (310) accommodating passage of the common robot (305) for conveying wafers to each processing unit, and the rear side of each processing unit faces an access corridor (306), and the back wall of each vacuum chamber is provided with an access door for access to the respective processing units.

The plurality of processing units may be arranged in two rows having a central common aisle. The two rows of processing units may be arranged opposite each other with the central common aisle between them, and the two rows of processing units may also be stacked vertically, both rows facing the central common aisle.

### BRIEF DESCRIPTION OF THE DRAWINGS

Various aspects of the invention will be further explained with reference to embodiments shown in the drawings wherein:

FIG. 1 is a simplified schematic drawing of an embodiment of a charged particle lithography system;

FIG. 2 is a cross section view showing an embodiment of a charged particle source environment in a vacuum chamber;

FIG. 3 is a simplified block diagram of a modular lithography system;

FIGS. 4A and 4B show examples of arrangements of lithography machines and wafer loading system;

FIG. 5A is a perspective view of a vacuum chamber for a charged particle lithography system;

FIG. 5B is a side view of the vacuum chamber of FIG. 5A;

FIG. 5C is a front view of the vacuum chamber of FIG. 5A;

FIG. 5D is a cross section view of a portion of the vacuum chamber of FIG. 5A;

FIG. 6 is a detail view of a wall joint of a vacuum chamber;

FIG. 7A is a perspective drawing of a section of a vacuum chamber wall having mu metal layers;

FIG. 7B is a perspective drawing of a section of a vacuum chamber wall having a composite structure with a honeycomb layer;

FIG. 8A is a cross section view through a bottom wall of a vacuum chamber showing the interface with a frame supporting member;

FIG. 8B is a cross section view showing an alternative interface with a frame supporting member;

FIG. 8C is a cross section view showing another alternative interface with a frame supporting member;

FIG. 9A is a cross section view through the wall of a vacuum chamber showing a port lid and mu shield cap;

FIG. 9B is a cross section view showing an alternative arrangement for a port lid and mu shield cap;

FIG. 9C is a cross section view showing a second alternative arrangement for a port lid and mu shield cap;

FIG. 10A is a perspective view of an alternative arrangement of ports and vacuum pump openings in a vacuum chamber;

FIG. 10B is a top view of another alternative arrangement of ports and vacuum pump openings in a vacuum chamber;

FIG. 11 is a schematic diagram of vacuum chambers sharing turbo vacuum pumps;

FIG. 12A is a rear perspective view of an alternative embodiment of a vacuum chamber;

FIG. 12B is a front perspective view of the vacuum chamber of FIG. 12A; and

FIG. 12C is a detail view of the vacuum chamber of FIG. 12A.

### DESCRIPTION OF ILLUSTRATIVE EMBODIMENTS

The following is a description of various embodiments of the invention, given by way of example only and with reference to the drawings.

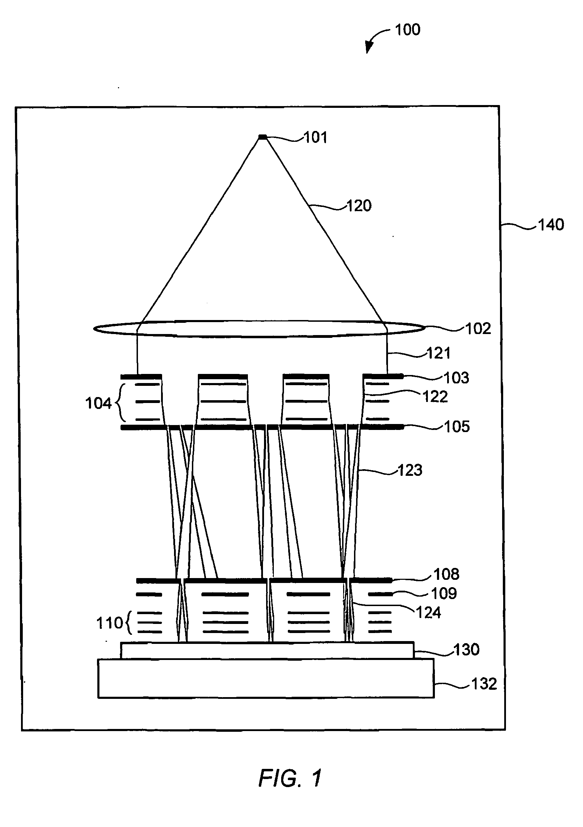

FIG. 1 shows a simplified schematic drawing of an embodiment of a charged particle lithography system 100. Such lithography systems are described for example in U.S. Patent Nos. 6,897,458 and 6,958,804 and 7,019,908 and 7,084,414 and 7,129,502, U.S. patent application publication no. 2007/0064213, and co-pending U.S. patent applications Serial Nos. 61/031,573 and 61/031,594 and 61/045,243 and 61/055,839 and 61/058,596 and 61/101,682, which are all assigned to the owner of the present invention. In the embodiment shown in FIG. 1, the lithography system comprises an electron source 101 for producing an expanding electron beam 120. The expanding electron beam 20 is collimated by collimator lens system 102. The collimated electron beam 121 impinges on an aperture array 103, which blocks part of the beam to create a plurality of beamlets 122. The system generates a large number of beamlets 122, preferably about 10,000 to 1,000,000 beamlets.

The electron beamlets 122 pass through a condenser lens array 104 which focuses the electron beamlets 122 in the plane of a beam blanker array 105, comprising a plurality of blankers for deflecting one or more of the electron beamlets. The deflected and undeflected electron beamlets 123 arrive at beam stop array 108, which has a plurality of apertures. The beamlet blanker array 105 and beam stop array 108 operate together to block or let pass the beamlets 123. If beamlet blanker array 105 deflects a beamlet, it will not pass through the corresponding aperture in beam stop array 108, but instead will be blocked. But if beamlet blanker array 105 does not deflect a beamlet, then it will pass through the corresponding aperture in beam stop array 108, and through beam deflector array 109 and projection lens arrays 110.

Beam deflector array 109 provides for deflection of each beamlet 124 in the X and/or Y direction, substantially perpendicular to the direction of the undeflected beamlets, to scan the beamlets across the surface of target 130. Next, the beamlets 124 pass through projection lens arrays 110 and are projected onto target 130. The projection lens arrangement preferably provides a demagnification of about 100 to 500 times. The beamlets 124 impinge on the surface of target 130 positioned on moveable stage 132 for carrying the target. For lithography applications, the target usually comprises a wafer provided with a charged-particle sensitive layer or resist layer.

The charged particle lithography system operates in a vacuum environment. A vacuum is desired to remove particles which may be ionized by the charged particle beams and become attracted to the source, may dissociate and be deposited onto the machine components, and may disperse the charged particle beams. A vacuum of at least 10⁻⁶ Bar is typically required. In order to maintain the vacuum environment, the charged particle lithography system is located in a vacuum chamber 140. All of the major elements of the lithography system are preferably housed in a common vacuum chamber, including the charged particle source, projector system for projecting the beamlets onto the wafer, and the moveable wafer stage.

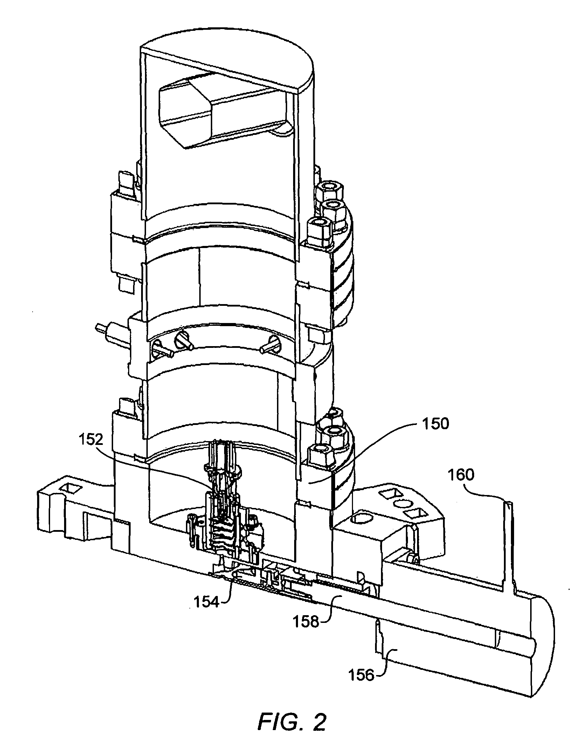

In an embodiment the charged particle source environment is differentially pumped to a considerably higher vacuum of up to 10⁻¹⁰ mbar. FIG. 2 is a cross section view showing an embodiment of a charged particle source environment in a vacuum chamber. In this embodiment, a considerably higher vacuum of up to 10⁻¹⁰ mbar may be obtained by differential pumping.

The differential pumping can be obtained by the inclusion in the vacuum chamber of a local source chamber 150 for the source 152. Although only a single source 152 is shown in FIG. 2, it must be understood that the source chamber 150 may comprise more sources. The high vacuum within the source chamber 150 may promote the life time of the source 152, and for some sources 152 may even be required for their functioning.

Pumping down the pressure level in the source chamber 150 may be performed in the following way. First, the vacuum chamber and the source chamber are pumped down to the level of the vacuum chamber. Then the source chamber is additionally pumped to a desired lower pressure, preferably by means of a chemical getter in a manner known by a skilled person. By using a regenerative, chemical and so-called passive pump like a getter, the pressure level within the source chamber 150 can be brought to a lower level than the pressure level in the vacuum chamber without the need of a vacuum turbo pump. The use of a getter avoids the interior or immediate outside vicinity of the vacuum chamber being submitted to acoustical and/or mechanical vibrations as would be the case if a vacuum turbo pump would be used for such a purpose.

In the embodiment shown in FIG. 2, the source chamber 150 is provided with a valve 154 for closing a connection between the source chamber 150 and the vacuum chamber if needed, that is if the pressure level within the source chamber 150 needs to be maintained at a much lower pressure level than the pressure level in the vacuum chamber. For example, the valve may be closed if the vacuum chamber is opened, for example for servicing purposes. In such a case a high vacuum level is maintained within the source chamber 150, which may improve downtime of the lithography apparatus. Instead of waiting until the pressure level within the source chamber 150 is sufficient, now only the vacuum chamber needs to be pumped down to a desired pressure level, which level is higher than the level needed in the source chamber 150.

The valve 154 is controlled by an actuation unit 156 that controls movement of a bar 158 that is coupled to the valve 154. The actuation unit 156 may comprise a piezo-electric actuator, for example Physikinstrumente model N-214 or N-215 NEXLINE^{®}. The actuation unit 156 may be connected to a control unit and/or a power supply (both not shown) by means of electric wiring 160. The wiring may be coated to shield electromagnetic radiation.

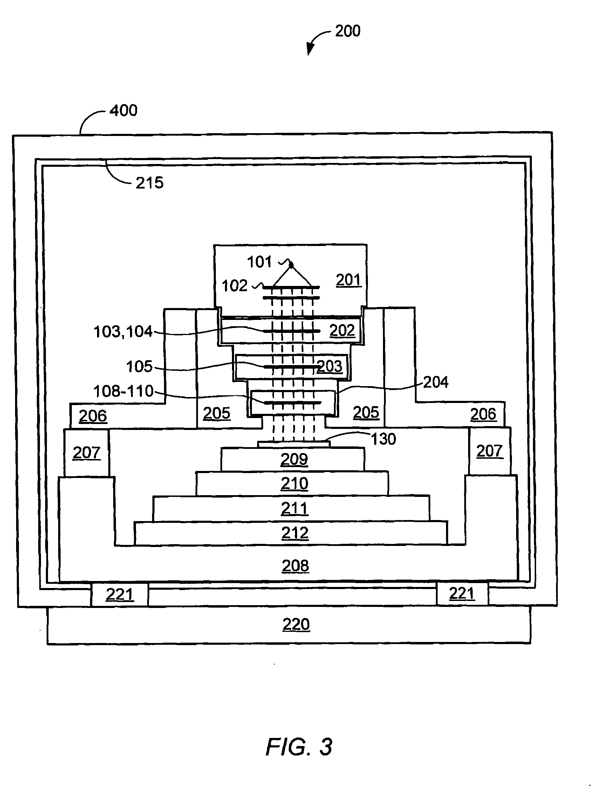

FIG. 3 shows a simplified block diagram illustrating the principal elements of a modular lithography system. The lithography system is preferably designed in a modular fashion to permit ease of maintenance. Major subsystems are preferably constructed in self-contained and removable modules, so that they can be removed from the lithography machine with as little disturbance to other subsystems as possible. This is particularly advantageous for a lithography machine enclosed in a vacuum chamber, where access to the machine is limited. Thus, a faulty subsystem can be removed and replaced quickly, without unnecessarily disconnecting or disturbing other systems.

In the embodiment shown in FIG. 3, these modular subsystems include an illumination optics module 201 including the charged particle beam source 101 and beam collimating system 102, an aperture array and condenser lens module 202 including aperture array 103 and condenser lens array 104, a beam switching module 203 including beamlet blanker array 105, and projection optics module 204 including beam stop array 108, beam deflector array 109, and projection lens arrays 110. The modules are designed to slide in and out from an alignment frame. In the embodiment shown in FIG. 3, the alignment frame comprises an alignment inner subframe 205 and an alignment outer subframe 206. A frame 208 supports the alignment subframes 205 and 206 via vibration damping mounts 207. The wafer 130 rests on wafer table 209, which is in turn mounted on chuck 210. Chuck 210 sits on the stage short stroke 211 and long stroke 212. The lithography machine is enclosed in vacuum chamber 400, which includes a mu metal shielding layer or layers 215. The machine rests on base plate 220 supported by frame members 221.

Each module requires a large number of electrical signals and/or optical signals, and electrical power for its operation. The modules inside the vacuum chamber receive these signals from control systems which are typically located outside of the chamber. The vacuum chamber includes openings, referred to as ports, for admitting cables carrying the signals from the control systems into the vacuum housing while maintaining a vacuum seal around the cables. Each module preferably has its collection of electrical, optical, and/or power cabling connections routed through one or more ports dedicated to that module. This enables the cables for a particular module to be disconnected, removed, and replaced without disturbing cables for any of the other modules.

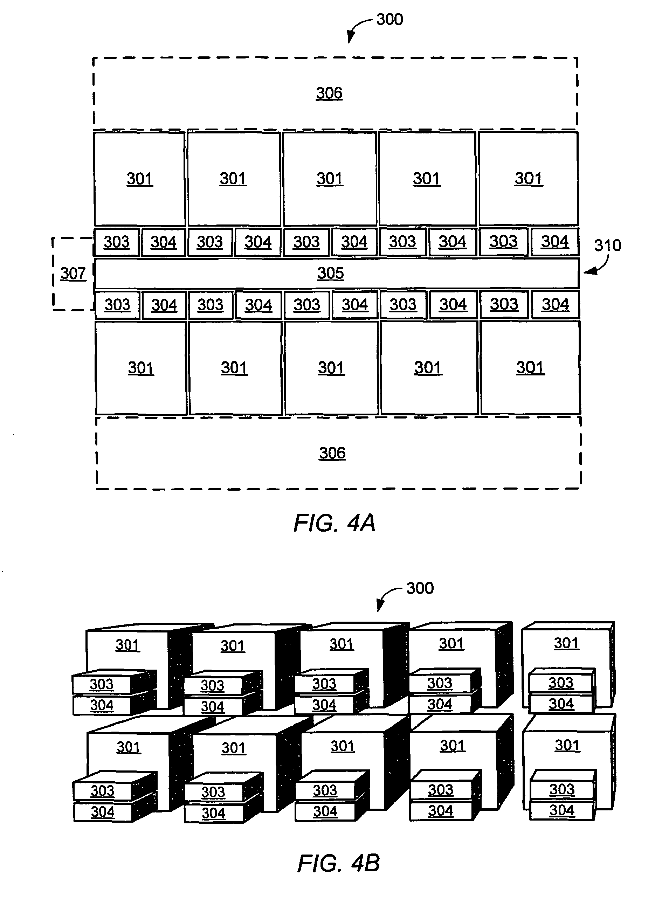

FIG. 4A shows an example of a layout of a group of lithography machines 300 cooperating with a common wafer loading system. In this example, ten lithography machines 301 are arranged in two rows of five. Each lithography system is contained in its own vacuum chamber, with the front of each chamber facing a central aisle 310 and the rear of each chamber facing an access corridor 306.

The central aisle accommodates a robot 305 for conveying wafers to each lithography machine 301, a load lock or wafer load unit 303 for each machine 301 loading wafers into the machine, and a stage actuator 304 for each machine for moving the machine's wafer stage inside its vacuum chamber. The common robot 305 may comprise more than one robot unit, each robot unit being configured to perform the functions assigned to the common robot 305. If a robot unit malfunctions, another robot unit may take over its function which minimizes the downtime of the layout due to robot failure. The malfunctioning robot unit may be discarded from the layout and transferred to a robot storage unit 307. The robot unit can then be serviced without disturbing the operation of the layout.

Each vacuum chamber includes a wafer loading opening in its front wall for receiving a wafer. The load lock (and the robot) is preferably disposed at about the height of the wafer stage of the lithography machine, i.e. more or less at half the height of the vacuum chamber. Although the load lock or wafer load unit 303 and the stage actuator 304 are shown side-by-side in FIG. 4A, these are preferably arranged with the load lock or wafer load unit 303 above the stage actuator 304 as shown in the arrangement in FIG. 4B. Each vacuum chamber also includes a door in its back wall for permitting access to the lithography machine for maintenance, repair, and operational adjustment.

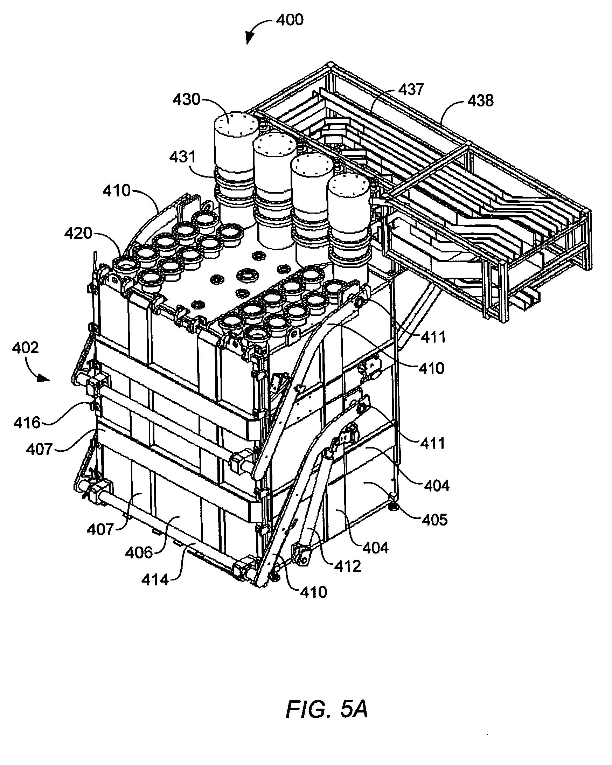

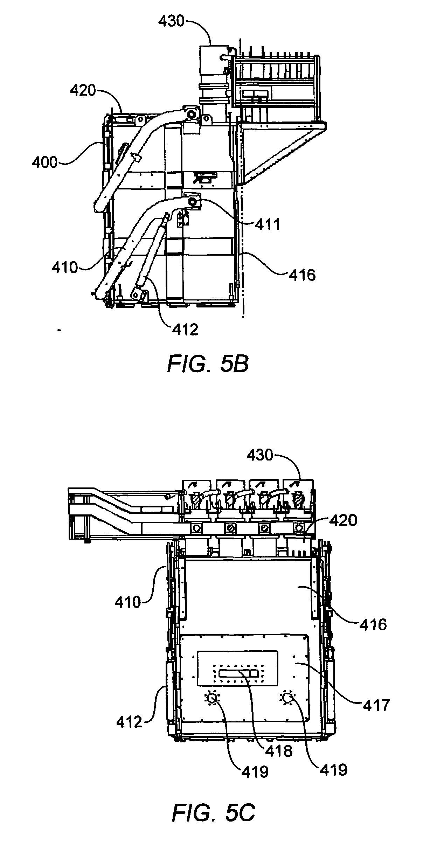

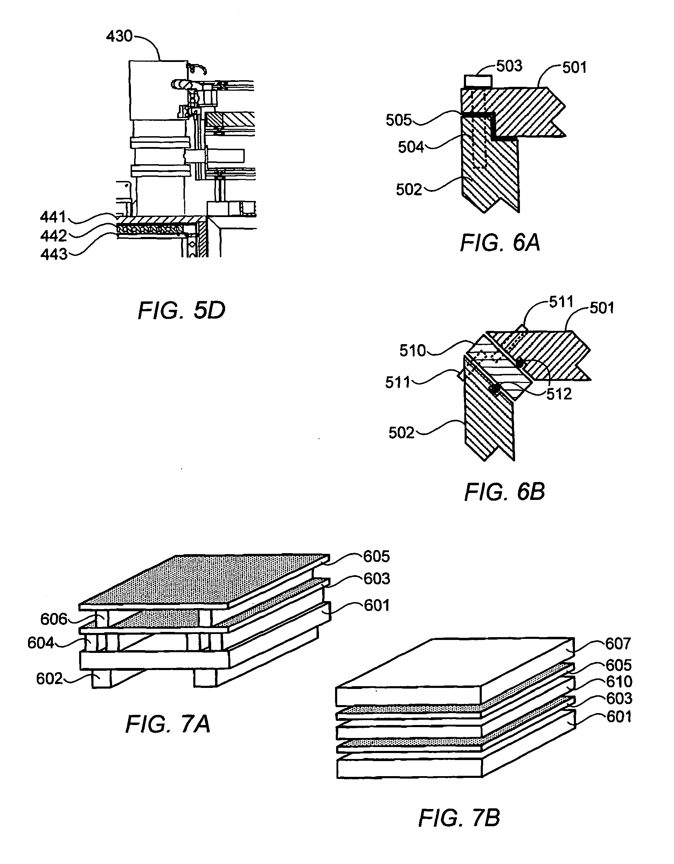

Each lithography machine is preferably disposed in its own vacuum chamber. All of the major elements of the charged particle lithography system are preferably housed in a common vacuum chamber, including the charged particle source, projector system for projecting the beamlets onto the wafer, and the moveable wafer stage. Various embodiments of a vacuum chamber 400 for housing a charged particle lithography system are described in detail below. The wafer handling robot and stage actuator for each machine may also be located in the same vacuum chamber with the lithography machine, or they may be located in separate vacuum chambers. The stage actuator will typically include electric motors, such as linear electric motors, which are preferably separated from the lithography machine by magnetic field shielding. This may be accomplished by providing one or more mu metal layers on the walls of the vacuum chamber housing the lithography machine, and locating the stage actuator in a separate chamber. FIGS. 5A-5D show an embodiment of a vacuum chamber 400 for housing a charged particle lithography system.

Floor space within a fab is valuable, due to the high cost to construct and operate fabs and the increase in cost as the size of the fab is increased. Efficient use of the fab floor space is thus important, and the lithography machines are preferably designed to consume as little floor space as possible and fit together with other machines as efficiently as possible.

The vacuum chamber preferably has a substantially square footprint (i.e. the floor of the chamber is square or approximately square). This enables an efficient arrangement for housing the lithography machine, typically designed for exposing a circular wafer, and producing an efficient arrangement of multiple lithography machines as shown, for example, in FIG. 4A. Furthermore, the chamber may have a box-like shape, preferably limited in height to allow further decrease of fab space occupation. In an embodiment, the chamber is shaped substantially cubically (i.e. the height of the chamber is approximately the same as its width and depth).

In an alternative arrangement, the vacuum chambers are stacked vertically as well as or in addition to being arranged side-by-side. FIG. 4B shows a perspective view of one row of vacuum chambers in such an arrangement. Two, three, or possibly more layers of vacuum chambers may be used, for example creating an arrangement of 20 chambers (for two layers) or 30 chambers (for three layers) in the same floor space as shown in FIG. 4A. Multiple chambers may utilize a common vacuum pumping system, and a common conveying robot system. Alternatively, a common vacuum pumping system and a common conveying robot system may be utilized for each layer of chambers, or for each row of chambers.

The embodiment shown in FIGS. 5A-5D comprises a vacuum chamber 400 with a door 402 in the back wall of the chamber, and in this example also forming the back wall. The embodiment further comprises a wafer loading slot 418 in the front wall of the chamber (shown in FIG. 5C), and ports 420 and vacuum pumps 430 on the top wall of the chamber, in this example so-called turbo-pumps. The chamber 400 may be constructed from stainless steel, aluminum, or other suitable materials, or a combination of these materials. Lighter materials such as aluminum are preferred to reduce the weight of the chamber, which is particularly important when it is anticipated the lithography machine will be transported from the factory to fab site by air (which may be preferred to avoid corrosion and other problems caused by sea transport).

Cross beams or girders 404 may be used for reinforcing the wall plates 405, so that a thinner plate thickness may be used for the walls to reduce the weight and cost of the chamber. However, for some walls of the chamber this construction is not preferred, for example for the walls where openings are located. These walls are preferably constructed of thicker plates to provide the required rigidity despite having openings.

The walls of the chamber 400 may be welded together at their edges. However, welding the walls can be slow and expensive, for example because it may be complicated to make a precision airtight weld without deforming the vacuum chamber walls. An alternative construction is a construction made by gluing the walls together at their edges, as shown in the example in FIG. 6A. Two walls 501 and 502 with stepped edges are interlocked as shown in the drawing with an adhesive 505 applied between the adjoining surfaces. An example of a suitable adhesive is Araldite 2020. A bolt or locating pin 503 in recess 504 extending through the wall 501 into the wall 502 may be used to locate the walls 501, 502 during the gluing process. An alternative construction method is shown in FIG. 6B. The edges of the walls 501 and 502 are angled and a strip 510 may be positioned between the edges of the walls. Locating bolts or pins 511 may be used to locate the walls and the strip, and O-rings 512 may be used to seal the joints between the walls and the strip 510. The bolts 511 are included outside of the O-rings 512. This construction results in a self-clamping arrangement where the pressure created by the vacuum in the chamber helps to pull the wall joints together and create a better seal. Strip 510 together with corner pieces connecting the strip with similar strips with different orientations, may form a self-bearing framework that is incorporated into the vacuum chamber walls, including walls 501 and 502. Although the chamber walls are illustrated as solid walls in FIGS. 6A and 6B, the walls preferably use the sandwich construction as described below.

The walls of the vacuum chamber preferably also include one or more mu metal layers, to provide isolation from magnetic fields external to the chamber. Such magnetic fields may influence the electron beams and interfere with correct operation of the lithography system. The mu metal may be included on the inside surface of the chamber walls, or sandwiched within the wall construction between layers of other material. Alternatively, the mu metal may be included on the outside surface of the chamber walls. Parts protruding the chamber, such as leg or supports of the lithography machine (wafer stage and charged particle column) and actuator rods for the stage, are covered by a bellows construction of mu metal, i.e. a mu metal construction extending outside the chamber.

The strip 510 is shown as a single piece, but it may be constructed as a sandwich as well, e.g. alternating insulating layers and mu metal layers, terminating with an aluminum layer on the vacuum (interior) side of the strip. In this way the shielding in the chamber walls can be continued uninterrupted through the entire structure of FIG. 6B resulting in a kit-set style vacuum chamber with the shielding entirely incorporated (and continuous) in the structure of the vacuum chamber.

FIG. 7A shows an embodiment of a vacuum chamber with two layers of mu metal. A section of the chamber wall 601 is shown with reinforcing beams 602 on the outside surface of the wall, for example reinforcing beams or girders 407 in FIG. 5A. A first mu metal layer 603 has spacing members 604 in the form of ribs between the mu metal layer 603 and chamber wall 601, to create a space between them. A second mu metal layer 605 has spacing members 606 between the two mu metal layers, to create a space between them. The mu metal layers have holes in them to avoid pressure differences in the vacuum chamber when the chamber is evacuated.

FIG. 7B shows an alternative embodiment of a vacuum chamber with an open layer 610 separating the two layers of mu metal 603 and 605, where the layer 610 preferably has an open structure such as a honeycomb. The layers are shown separated in the drawing for clarity, but the layers would be formed into a single composite wall in practice. The layer 610 provides a light-weight but rigid wall separating the two mu metal layers rendering a sandwich construction, so that the spacing members 604 and 606 in the embodiment of FIG. 7A can be dispensed with. This construction may also enable the reinforcing beams 602 on the outside surface of the wall 601 to be eliminated. A second wall 607 may also be provided. The walls 601 and 607 are preferably made from aluminum, and the layer 610 is preferably an aluminum honeycomb. The resulting composite wall structure provides a wall that is easy and cheap to manufacture, can be prefabricated, and is lightweight and rigid, with the honeycomb layer providing the required strength for the wall. Furthermore, the composite wall structure may incorporate one or more layers ofmu shielding.

The mu metal layers are preferably separated from conducting layers by an insulating layer, such as a composite layer of carbon fiber and/or glass reinforced plastic. One embodiment of the composite wall comprises a sandwich construction comprising a first insulating layer, an aluminum honeycomb layer, a mu metal layer, a second insulating layer, and a solid aluminum layer. Additional sets of mu metal layers and insulating layers may be added to increase the magnetic field shielding of the chamber wall. The solid aluminum layer is preferably on the vacuum side. The honeycomb aluminum provides the strength of the sandwich. The thickness of the honeycomb layer may be increased, or additional honeycomb layers used to increase the stiffness of the wall. The layers are preferably glued together. When the open layer 610 is made from an insulating material, this can itself provide an insulating layer to separate the mu metal layers. A composite chamber wall using this construction provides a light weight and rigid wall that can be prefabricated, and designed with the required level of magnetic shielding. This structure incorporates the mu metal shielding into the wall of the vacuum chamber, and avoids using thick solid metal layers to obtain the required strength. Note that any of the composite walls described above may be used in any of the embodiment of the vacuum chamber described herein.

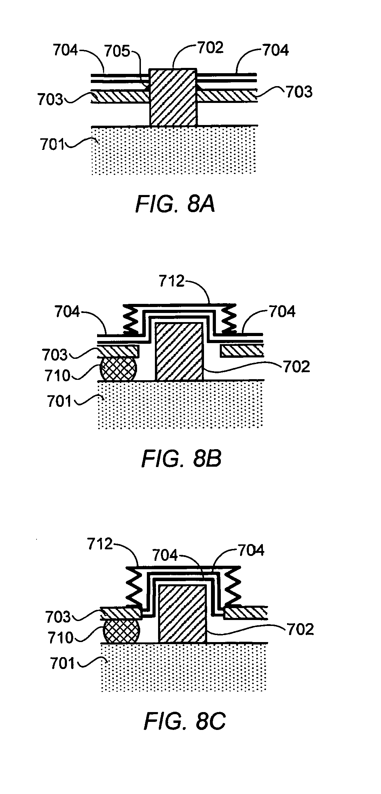

FIG. 8A shows a cross section through the bottom wall (floor) of the vacuum chamber 400 where it interfaces with the frame supporting the lithography machine housed in the chamber. Frame member 702 is shown extending through the chamber wall and resting on base plate 701. Chamber walls 703 abut the frame member 702 and may be welded to the frame member (weld 705). Two mu metal layers 704 also abut the frame member 702 to avoid gaps which can permit external magnetic fields to enter the chamber.

In order to reduce acoustic and vibrational coupling between the base plate 701 and the vacuum chamber 400 which can affect the stability of the lithography machine, alternative embodiments are shown in FIGS. 8B and 8C. In these embodiments, the chamber walls 703 are not rigidly fixed to frame member 702, and have a small gap between the walls and the frame member. The walls are supported in part by a vibration damping element 710 such as an air mount. The mu metal layers 704 extend over, or, alternatively, underneath, the frame member 702 to eliminate any gaps in the shield. A bellows section 712 may also be provided, extending over the frame member 702, to provide additional support to the chamber wall and providing additional sealing around the frame member while permitting some flexing to reduce mechanical coupling between the base plate and the chamber walls. In the embodiment of FIG. 8B, the bellows section 712 is coupled to the mu metal layers 704. In the embodiment of FIG. 8C, the bellows section 712 is coupled to the chamber walls 703 instead. Additionally, the mu metal layers 704 are coupled to the chamber walls 705, e.g. by clamping.

The lithography machine requires a large number of electrical and optical signals to operate, which must exit the vacuum chamber for connection to control systems which are typically located outside the chamber. The vacuum housing includes openings, referred to as ports, for admitting cables carrying the signals from the control systems into the vacuum housing. The ports are designed to make a vacuum seal around the cables. The lithography system preferably has a modular construction so that various critical subsystems can be removed from the system and replaced without disturbing other subsystems. To facilitate this design, each such modular subsystem preferably has its collection of electrical, optical, and/or power cabling connections routed through one or more ports dedicated to that module. This enables the cables for a particular module to be disconnected, removed, and replaced without disturbing cables for any of the other modules. The ports are preferably designed to facilitate the removal and replacement of the cables, connectors, and port lids as a unit, for example an electronic unit. The vacuum chamber also requires openings for one or more vacuum pumps to pump air from the chamber to evacuate the chamber.

In the embodiment shown in FIGS. 5A-5D, the ports 420 and vacuum pumps 430 are located on the top wall of the chamber 400. In this embodiment, four vacuum pumps 430, e.g. turbo pumps, are provided in cylindrical housings along the front side of the top wall, connected to vacuum pump openings 431, and twenty cylindrical ports 420 are provided arranged on both sides of the top wall. The cabling from the ports is routed to the associated control systems via conduits 437 arranged in cable rack 438.

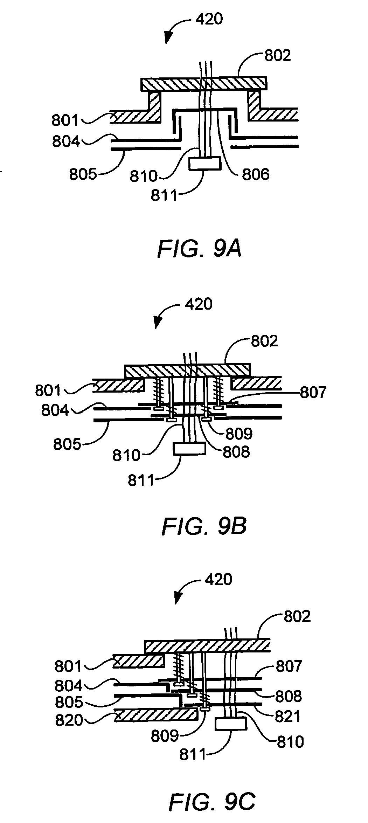

FIG. 9A shows a cross section through the top wall (ceiling) of the vacuum chamber 400, showing a port 420. A portion 801 of the top wall is shown with an opening closed off by lid 802. Two mu metal layers 804 and 805 also have a corresponding opening. The upper mu metal layer 804 has a cap 806 fitting over a lip in the layer 804, providing a complete shielding layer when the cap is in place. Cables 810 enter the vacuum chamber through the port lid 802 and the cap 806, and terminate in connector 811. The opening in the mu metal layers must be sufficiently large for the connector 811 to pass through, so that the assembly of the connector 811, cables 810, cap 806, and lid 802 can be removed and replaced when necessary.

FIG. 9B shows an alternative embodiment of the port 420. Each mu metal layer 804, 805 has a cap 807, 808. The mu metal caps are attached to the lid 802 via bolts or connecting pins 809, with springs or spring-like elements. When the port is closed, the mu metal caps 807 and 808 are pushed against the respective mu metal layers 804 and 805 to produce a positive closure of the caps over the opening in the mu metal layers. This ensures there are no gaps in the mu metal layers when the port is closed. The structure also fixes the mu metal caps 807 and 808 to the port lid 802.

FIG. 9C shows another alternative arrangement for the port 420. Only one side of the port is shown in the drawing for simplicity. In this arrangement, the chamber wall includes a second wall layer 820, and a third mu metal cap 821 is also included. The three mu metal caps are attached to the lid 802 via bolts or connecting pins 809, with springs or spring-like elements, as in the previous embodiment. When the port is closed, the mu metal caps 807 and 808 are pushed against the respective mu metal layers 804 and 805 and the mu metal cap 821 is pushed against wall layer 820. Each mu metal layer 804 and 805 has a lip to further ensure that there are no gaps in the shielding. Alternatively or in addition, the mu metal caps may be provided with lips.

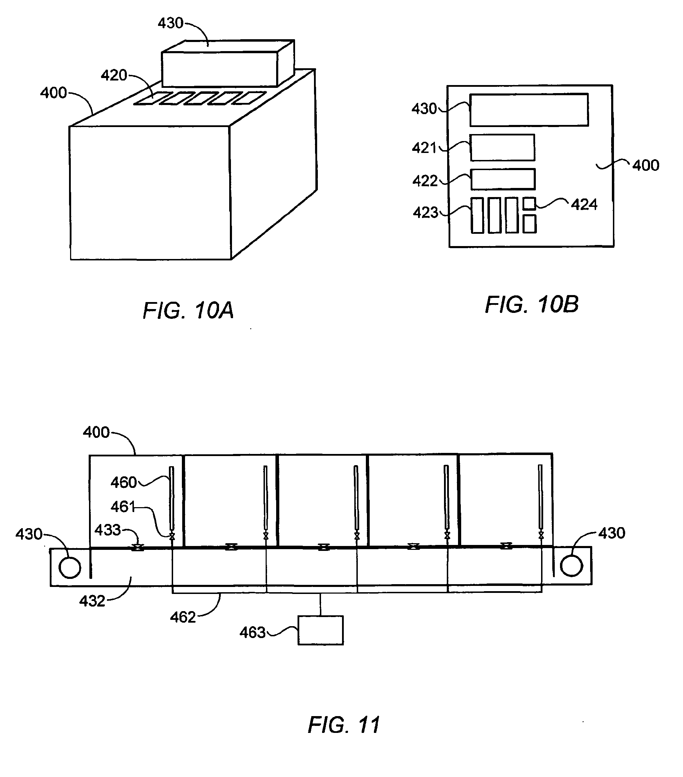

The ports 420 and vacuum pump openings 431 may be circular in design as shown in FIGS. 5A-5D, or square or rectangular as shown in FIG. 10A. The ports are preferably dedicated to a particular modular subsystem of the lithography machine, and may be sized according to the number of cabling connections required for a subsystem. For example, as shown in FIG. 10B, the illumination optics subsystem may require a large port 421, the projection optics subsystem a slightly smaller port 422, and the other subsystems smaller ports 423 and 424.

A vacuum chamber 400 may have one of more dedicated vacuum pumps 430. Also, one or more vacuum pumps may be shared between several vacuum chambers. Each chamber may have a small vacuum pump, and share a larger vacuum pump. The ability to use more than one pump to realize a vacuum in the vacuum chamber 400 creates a vacuum pump redundancy that may improve the reliability of vacuum operation. If a vacuum pump malfunctions, another vacuum pump can take over its function.

FIG. 11 shows an arrangement with five vacuum chambers 400 sharing two turbo vacuum pumps 430. The vacuum pumps are arranged at each end of a shared duct or pipe 432. In an embodiment, the pumps 430 and the duct or pipe 432 serve two rows of chambers 400 from a central position. The number of shared pumps may vary, i.e. one or more. The duct or pipe 432 is connected to each vacuum chamber via a flap or valve 433. The flap or valve 433 preferably is made of mu metal or includes a mu metal layer to provide shielding.

A water vapor cryopump 460, for example in the form of one or more cryopump shields, may additionally be included in each vacuum chamber to capture water vapor in the chamber to assist in forming the vacuum in the chamber. This reduces the size of the vacuum pumps needed to produce an adequate vacuum and reduces pumpdown time, and uses no moving parts so that it does not introduce vibrations typically caused by other types of low temperature (<4K) systems. The water vapor cryopumps 460 are connected via valve 461 and refrigerant supply line 462 to cryopump control system 463.

The vacuum in the vacuum chambers of the arrangement shown in FIG. 11 can thus be generated by both the turbo vacuum pumps 430 and the water vapor cryopumps 460 of the cryopump system. Preferably, the turbo pumps 430 are activated first followed by activation of the cryopump system by means of cryopump control system 463 to generate the vacuum. Activation of a turbo vacuum pump 430 prior to a water vapor cryopump 460 may lead to a more efficient vacuum pumping procedure than other control schemes of vacuum pumping activation. To further enhance efficiency, the turbo pump or pumps 430 may be isolated from the vacuum chamber after a certain period of time following its activation. Such a period of time may correspond to a time needed to obtain a pressure value below a certain predetermined threshold value. After isolation of the turbo pump or pumps 430 the water vapor cryopump 460 may continue to operate to complete generation of the vacuum.

The arrangement shown in FIG. 11 may be modified to accommodate multiple layers of stacked vacuum chambers, with vacuum chambers being stacked vertically as well as or in addition to being arranged side-by-side. Two, three, or possibly more layers of vacuum chambers may be used, for example creating an arrangement of 10 chambers (for two layers) or 15 chambers (for three layers) in the arrangement shown in FIG. 11. Multiple chambers may utilize a common vacuum pumping system and a common vacuum pumping system may be utilized for each layer of chambers. In an embodiment, a vacuum in a vacuum chamber belonging to a set of vacuum chambers may be realized by pumping down each chamber separately by the common vacuum pumping system.

Referring back to FIGS. 5A-5D, the door 402 preferably forms the entire back wall of the chamber 400. Although this arrangement creates several problems, it also provides an important advantage. The large size of the door in this design increases the length of the sealing edge around the door, making it more difficult to maintain a vacuum in the chamber. To achieve a good seal, the door must be very flat and rigid, which is more difficult to achieve due to its large size, and results in a heavier door making it more difficult to open and close. The large size requires more free space around the chamber to accommodate the usual swinging door, using up valuable floor space in the fab. However, a door forming the entire back wall of the chamber provides maximum width and height for moving components of the lithography system into and out of the chamber, which is an important advantage in a lithography system having a modular design. It allows sliding out of a module, and subsequently exchanging it, for example to be serviced, without a need to enter the vacuum chamber.

The door 402 may be constructed from stainless steel, aluminum, or other suitable materials or combination of materials including a sandwiched wall construction, for example as described earlier. The door preferably includes one or more mu metal layers, similarly to the chamber walls, to provide isolation from external magnetic fields. To reduce the weight of the door while maintaining the required rigidity, the door panel 406 preferably includes vertical and/or horizontal reinforcing beams or girders 407. The outer edge of the door may also be reinforced, for example by a strip-like reinforcement member attached to the outside or inside perimeter of the door.

The door preferably opens upwards, substantially vertically, to minimize the floor space required for the lithography machine. This arrangement permits other equipment or a wall to be located in relatively close proximity to back side of the lithography machine, or avoids having the door block required working or access space.

In some embodiments the door is mounted on hinged arms to enable the door to swing upwards. The embodiment in FIGS. 5A-5D uses this design. This embodiment employs two arms 410 on each side of the door in a parallelogram arrangement. The arms 410 are rotatably attached to the door 402 via rods 414. The arms 410 permit the door 402 to move in an arc, with the arms extending downwards from a hinging point 411 when the door is in the closed position, and extending upwards when the door is in the open position.

An actuation member 412, such as an electric screw spindle, may be provided to assist with opening and closing the door 402, to counteract in part the weight of the door. The actuation member 412 extends obliquely upwardly with its lower end near the door and its higher end connecting to one of the arms 410 further from the door and near the pivot point 411 of the arm. Alternative means may also be provided for this purpose, e.g. counterweights or springs. The weight of the door 402, combined with the geometry of the arms 410, pushes the door against the chamber walls when in the closed position. As shown in FIG. 5A, the arms 410 are relatively long and assume a relatively steep angle to the vertical when the door is closed, so that a large closing force is provided by the weight of the door 402 and the force of gravity. This closing force is preferably sufficient to achieve the initial sealing required to develop a vacuum in the chamber.

The outer edge of the door 402 forms a seal against the walls of the vacuum chamber 400. For this purpose, a flat strip may be attached to the upper, lower and side walls of the chamber to mate with a corresponding flat area around the perimeter of the door. An O-ring, and preferably two O-rings arranged as an inner and outer O-ring, are provided on the surface of the flat strip or the door perimeter.

In order to provide satisfactory sealing so that the required vacuum can be maintained in the vacuum chamber, the door should be substantially flat so that it fits against the walls of the chamber without gaps. The door preferably fits against the chamber with a maximum play of about 0.1 mm, to allow the vacuum pumping system to create sufficient vacuum pressure in the chamber so that the door is pressed against the O-rings by the ambient pressure outside the chamber to allow full vacuum pressure to be achieved. The required flatness of the door can be achieved by flattening the outer edges of the door after it has been constructed, e.g. by milling.

The closing force due to the weight of the door and the geometry of the arms is preferably sufficient to achieve the initial sealing without requiring additional force to be applied to the door. If the initial sealing is achieved, operation of the vacuum pumping system will pull the door against the O-rings and full vacuum pressure in the chamber can be achieved. Locking lugs or bolts 416 can also be used to ensure the door 402 is sealed against the chamber walls.

A panel 417 is located in the front wall of the vacuum chamber 400, including a slot 418 for receiving wafers from a wafer load system. Additional openings 419 are also included for actuator rods to enter the vacuum chamber from a stage actuator outside the chamber. The stage actuator moves the stage inside the chamber to enable scanning of the wafer by the lithography machine. The stage actuator typically uses electric motors to produce the required mechanical movement of the stage, and these electric motors generate electromagnetic fields which can disturb the charged particle beams used by the lithography machine. To avoid this disturbance, the stage actuator is located outside the mu metal shield of the chamber. Rods from the stage actuator enter the vacuum chamber through holes 419 in the chamber wall to move the stage inside the chamber. The front wall of the vacuum chamber is preferably constructed of thicker solid plate to accommodate the openings.

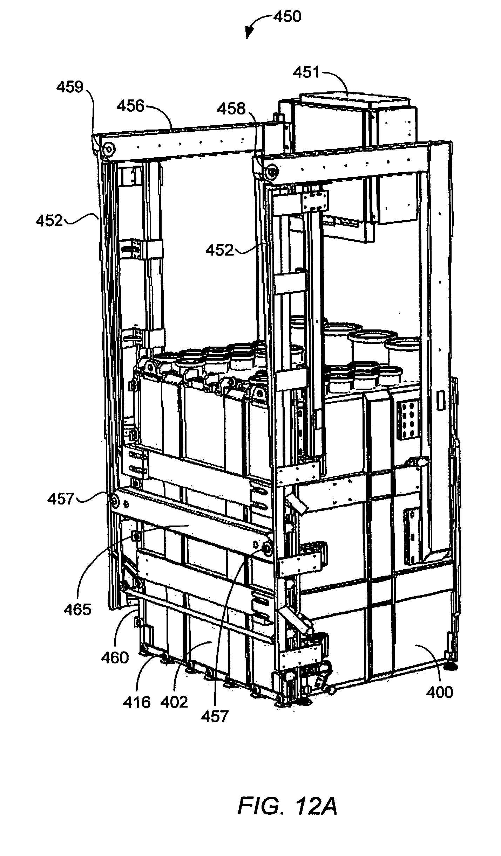

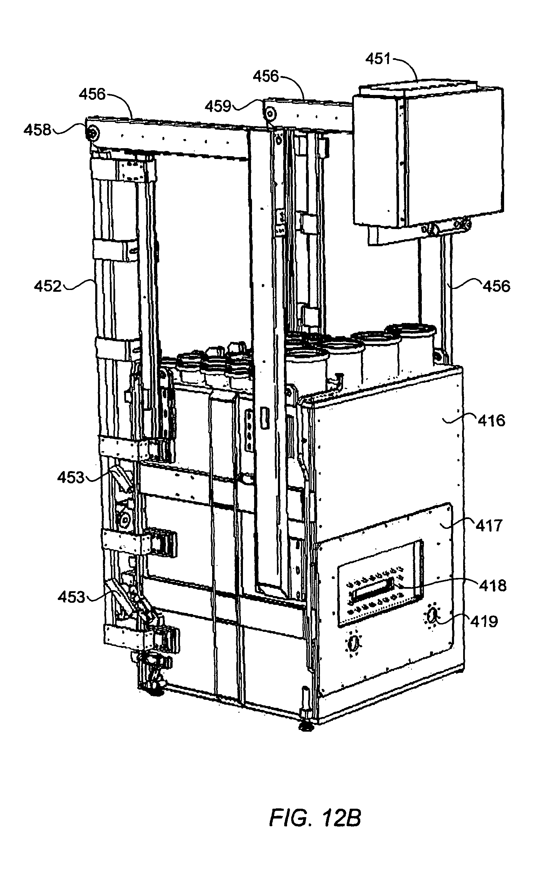

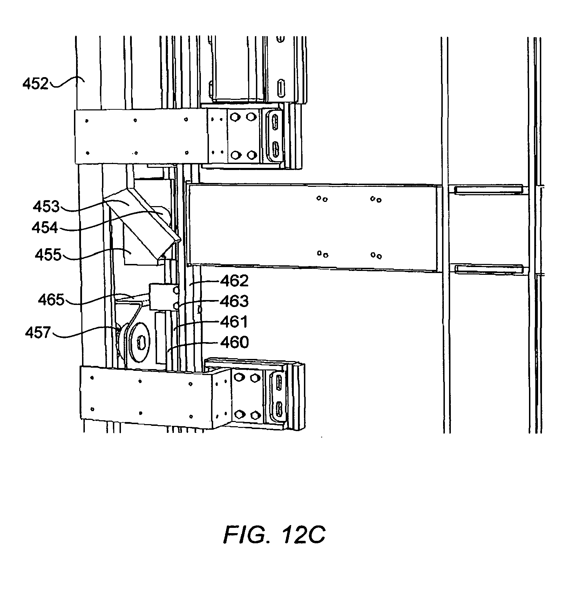

In some embodiments of the vacuum chamber, the door is opened by a lift system, the door being guided on each side of the door as it lifts. One such embodiment shown in FIGS. 12A-12C, has a lift system 450 comprising an electric hoist 451 for lifting the door 402 using a chain on each side of the door. A suitable hoist for this embodiment is, for example, Demag hoist model DCS-Pro 5-500. A winch may also be used with cables, wires, ropes, or other flexible lift elements or other inflexible lift elements such as a gear rack. However, a chain is preferred for low elasticity, due to its suitability for clean room environments, due to the constant angle and position of the chain leaving and entering the hoist (in contrast to a cable changing angle and position as it is wound onto the drum of a winch), and due to its flexibility in all directions.

The lift system 450 is provided with guiding elements for guiding the door at least in a first stage of opening in both vertical and horizontal directions. Door guides 452, supported by a frame 456, are provided on each side of the door in the form of guide rails running substantially vertically, with an inclined portion 453 at the lower ends bringing the guide rails towards the door 402 at an angle of about 45 degrees. Guide pins or rollers 454 (preferably with protrude from each side of the door for engagement with the guide rails 452, the guide pins sliding along the trough formed by the guide rails as the door opens and closes. The guide pins 454 may be connected directly to the door panel or preferably to door reinforcing beams 455. When the door 402 is being opened, the configuration of the door guides 452 results in the door initially moving upwards and outwards (at an angle of 45 degrees in this embodiment), followed by a vertical or almost vertical movement until the door is raised completely above the top wall of the vacuum chamber to provide unhindered access to the chamber interior.

When the door 402 is being closed, the door initially moves vertically or almost vertically and then closes against the chamber moving downwards and inwards at an angle. As for the previous embodiment, the door preferably fits against the chamber with a maximum play of about 0.1 mm. The closing force due to the weight of the door and the geometry of the door guides is preferably sufficient to achieve the initial sealing without requiring additional force to be applied to the door. If the initial sealing is achieved, operation of the vacuum pumping system will pull the door against the O-rings and full vacuum pressure in the chamber can be achieved. Lesser initial sealing may to some extent be compensated though by using high capacity pumps in a shared configuration, for example a configuration as discussed earlier with reference to FIG. 11. Locking lugs or bolts 416 can also be used to ensure the door 402 is sealed against the chamber walls.

The outer edge of the door 402 may also be reinforced, for example by a strip-like reinforcement member 460 attached to the outside or inside perimeter 461 of the door. The outer edge of the door forms a seal against the walls of the vacuum chamber. A flat strip 463 may be attached to the upper, lower and side walls of the chamber to mate with a corresponding flat area 461 around the perimeter of the door. An O-ring, and preferably two O-rings arranged as an inner and outer O-ring, are provided on the surface of the flat strip 463 or the door perimeter 461.

Guiding elements 457 are also provided to guide the chain as the door 402 is opened and closed. In the embodiment of FIGS. 12A-12C, a chain-gutter is provided alongside the door guides 452. The chain is attached at one end to the frame on one side of the chamber at point 458. The chain runs down the right side door guide 452, around a right chain guiding element 457, across the outer side of the door 402 in channel 465, around a left chain guiding element 457, up the left side door guide 452, around a third chain guiding element (459) at the upper end of the frame 452, and across to the hoist 451. This arrangement reduces required lifting force by half while using only one hoist.

The chain guides 457 are preferably located lower on the door 402, below or connected to a door reinforcing beam, and are preferably constructed as a roller, wheel, or other element able to guide the chain while transmitting the lifting force to the door.

Although a chain system is used for this embodiment, other lift elements may be used, either attached directly to the door or transmitting lifting force via guiding blocks or rollers attached to the door. A pneumatic or hydraulic lift system may also used, lifting the door via flexible lift elements or rigid arms or struts.

The hoist or winch motor or actuator is preferably located above the chamber, supported by frame 456. This makes efficient use of the fab floor space, as the lifting equipment then uses vertical space that is required to accommodate the opening height of the door. The winch or crane may be self locking, or provided with a locking device for safety purposes. Equipment racks may also be conveniently located above the vacuum chamber, also supported by the frame 456. These racks are preferably used to house high voltage control circuitry and beam switching and beam scan deflection circuitry, which is preferably located in close proximity to the lithography machine in the vacuum chamber. This makes efficient use of the fab floor space.

The invention has been described by reference to certain embodiments discussed above. It should be noted various constructions and alternatives have been described, which may be used with any of the embodiments described herein, as would be know by those of skill in the art.

## Claims

1. An arrangement comprising a plurality of charged particle lithography apparatuses, each charged particle lithography apparatus having a vacuum chamber (400), the arrangement further comprising:
a common robot (305) for conveying wafers to the plurality of lithography apparatuses; and
a wafer load unit (303) for each charged particle lithography apparatus arranged at a front side of each respective vacuum chamber (400);
wherein the plurality of lithography apparatuses are arranged in a row with the front side of the lithography apparatuses facing an aisle (310) accommodating passage of the common robot (305) for conveying wafers to each apparatus; and
wherein the rear side of each lithography apparatus faces an access corridor (306), and the back wall of each vacuum chamber is provided with an access door for access to the respective lithography apparatus.

2. The arrangement of claim 1, wherein the plurality of lithography apparatuses is arranged in two rows having a central common aisle.

3. The arrangement of claim 2, wherein the two rows of lithography apparatuses are arranged opposite each other with the central common aisle between them.

4. The arrangement of claim 2, wherein the two rows of lithography apparatuses are stacked vertically, both rows facing the central common aisle.

5. The arrangement of claim 1, wherein the plurality of lithography apparatuses is arranged in a plurality of rows having a central common aisle, wherein at least two of the rows of lithography apparatuses are arranged opposite each other with the central common aisle between them, and at least two of the rows of lithography apparatuses are stacked vertically, both rows facing the central common aisle.

6. The arrangement of any one of the preceding claims, wherein a stage actuator (304) for each charged particle lithography apparatus is disposed at a front side of each respective lithography apparatus.

7. The arrangement of any one of the preceding claims, wherein a stage actuator (304) comprising actuation members or rods is provided for each charged particle lithography apparatus for moving a stage inside each respective chamber (400).

8. The arrangement of claim 6 or claim 7, wherein each lithography apparatus is provided with a load lock unit (303) at its front wall, and wherein the load lock unit (303) is arranged above the stage actuator (304) of each respective lithography apparatus.

9. The arrangement of any one of the preceding claims, wherein the common robot comprises at least two robot units.

10. The arrangement of any one of the preceding claims, wherein the arrangement further comprises a robot storage unit (307).

11. The arrangement of claim 10, wherein the storage unit is arranged at an end of a row of lithography apparatuses adjacent to the aisle.

12. The arrangement of any of the preceding claims, wherein one or more of the lithography apparatuses in a row are stacked vertically, in two or more layers.

13. The arrangement of claim 12, wherein each lithography apparatus is provided with an individual support from a floor.

14. The arrangement of claim 12, wherein each layer of lithography apparatuses is provided with a separate support to a floor.

15. The arrangement of any on of the preceding claims wherein a lithography processing unit is arranged in each vacuum chamber (400).

## Patentansprüche

1. Anordnung, umfassend eine Vielzahl von geladene-Teilchen-Lithographie-Vorrichtungen, wobei jede geladene-Teilchen-Lithographie-Vorrichtung eine Vakuumkammer (400) aufweist, wobei die Anordnung weiterhin umfasst:
einen gemeinsamen Roboter (305) zum Transportieren von Wafern zu der Vielzahl von Lithographie-Vorrichtungen; und
eine Waferladeeinheit (303) für jede geladene-Teilchen-Lithographie-Vorrichtung, die auf der Vorderseite der jeweiligen Vakuumkammer (400) angeordnet ist;
wobei die Vielzahl von Lithographie-Vorrichtungen in einer Reihe angeordnet sind, wobei die Vorderseite der Lithographie-Vorrichtungen einem Gang (310) zugewandt sind, der den Durchtritt des gemeinsamen Roboters (305) ermöglicht, um Wafer zu jeder Vorrichtung zu transportieren; und
wobei die Rückseite jeder Lithographie-Vorrichtung einem Zugangskorridor (306) zugewandt ist und die Rückwand jeder Vakuumkammer mit einer Zugangstür versehen ist, um Zugang zu der jeweiligen Lithographie-Vorrichtung zu ermöglichen.

2. Anordnung gemäß Anspruch 1, wobei die Vielzahl von Lithographie-Vorrichtungen in zwei Reihen mit einem zentralen gemeinsamen Gang angeordnet ist.

3. Anordnung gemäß Anspruch 2, wobei die zwei Reihen von Lithographie-Vorrichtungen einander gegenüber angeordnet sind und sich der zentrale gemeinsame Gang dazwischen befindet.

4. Anordnung gemäß Anspruch 2, wobei die zwei Reihen von Lithographie-Vorrichtungen vertikal gestapelt sind, wobei beide Reihen dem zentralen gemeinsamen Gang zugewandt sind.

5. Anordnung gemäß Anspruch 1, wobei die Vielzahl von Lithographie-Vorrichtungen in einer Vielzahl von Reihen mit einem zentralen gemeinsamen Gang angeordnet ist, wobei wenigstens zwei der Reihen von Lithographie-Vorrichtungen einander gegenüber angeordnet sind und sich der zentrale gemeinsame Gang dazwischen befindet und wenigstens zwei der Reihen von Lithographie-Vorrichtungen vertikal gestapelt sind, wobei beide Reihen dem zentralen gemeinsamen Gang zugewandt sind.

6. Anordnung gemäß einem der vorstehenden Ansprüche, wobei sich ein Stelltisch/Aktor (304) für jede geladene-Teilchen-Lithographie-Vorrichtung auf einer Vorderseite der jeweiligen Lithographie-Vorrichtung befindet.

7. Anordnung gemäß einem der vorstehenden Ansprüche, wobei für jede geladene-Teilchen-Lithographie-Vorrichtung ein Stelltisch/Aktor (304) vorgesehen ist, der Stellglieder oder Positionierstangen umfasst, um einen Stelltisch innerhalb der jeweiligen Kammer (400) zu bewegen.

8. Anordnung gemäß Anspruch 6 oder 7, wobei jede Lithographie-Vorrichtung mit einer Ladeschleuseneinheit (303) an ihrer Vorderwand versehen ist und wobei die Ladeschleuseneinheit (303) oberhalb des Stelltisch/Aktors (304) der jeweiligen Lithographie-Vorrichtung angeordnet ist.

9. Anordnung gemäß einem der vorstehenden Ansprüche, wobei der gemeinsame Roboter wenigstens zwei Robotereinheiten umfasst.

10. Anordnung gemäß einem der vorstehenden Ansprüche, wobei die Anordnung weiterhin eine Roboter-Abstelleinheit (307) umfasst.

11. Anordnung gemäß Anspruch 10, wobei die Abstelleinheit an einem Ende einer Reihe von Lithographie-Vorrichtungen neben dem Gang angeordnet ist.

12. Anordnung gemäß einem der vorstehenden Ansprüche, wobei eine oder mehrere der Lithographie-Vorrichtungen in einer Reihe vertikal in zwei oder mehr Schichten gestapelt sind.

13. Anordnung gemäß Anspruch 12, wobei jede Lithographie-Vorrichtung mit einer individuellen Unterstützung vom Boden versehen ist.

14. Anordnung gemäß Anspruch 12, wobei jede Schicht von Lithographie-Vorrichtungen mit einer separaten Unterstützung zum Boden versehen ist.

15. Anordnung gemäß einem der vorstehenden Ansprüche, wobei in jeder Vakuumkammer (400) eine Lithographie-Verarbeitungseinheit angeordnet ist.

## Revendications

1. Agencement comprenant une pluralité d'appareils lithographiques à particules chargées, chaque appareil lithographique à particules chargées comportant une chambre à vide (400), l'agencement comprenant en outre:
un robot commun (305) pour transporter des tranches jusqu'à la pluralité d'appareils lithographiques; et
une unité de chargement de tranche (303) pour chaque appareil lithographique à particules chargées, agencée sur un côté avant de chaque chambre à vide respective (400);
dans lequel la pluralité d'appareils lithographiques sont agencés dans une rangée avec le côté avant des appareils lithographiques faisant face à une allée (310) permettant le passage du robot commun (305) pour transporter des tranches jusqu'à chaque appareil; et
dans lequel le côté arrière de chaque appareil lithographique fait face à un couloir d'accès (306), et la paroi arrière de chaque chambre à vide est pourvue d'une porte d'accès pour l'accès à l'appareil lithographique respectif.

2. Agencement selon la revendication 1, dans lequel la pluralité d'appareils lithographiques sont agencés en deux rangées comportant une allée commune centrale.

3. Agencement selon la revendication 2, dans lequel les deux rangées d'appareils lithographiques sont agencées l'une en face de l'autre avec l'allée commune centrale entre elles.

4. Agencement selon la revendication 2, dans lequel les deux rangées d'appareils lithographiques sont empilées verticalement, les deux rangées faisant face à l'allée commune centrale.

5. Agencement selon la revendication 1, dans lequel la pluralité d'appareils lithographiques sont agencés en une pluralité de rangées comportant une allée commune centrale, dans lequel au moins deux des rangées d'appareils lithographiques sont agencées l'une en face de l'autre avec l'allée commune centrale entre elles, et au moins deux des rangées d'appareils lithographiques sont empilées verticalement, les deux rangées faisant face à l'allée commune centrale.

6. Agencement selon une quelconque des revendications précédentes, dans lequel un actionneur d'étage (304) pour chaque appareil lithographique à particules chargées est disposé sur un côté avant de chaque appareil lithographique respectif.

7. Agencement selon une quelconque des revendications précédentes, dans lequel un actionneur d'étage (304) comprenant des éléments ou tiges d'actionnement est fourni pour chaque appareil lithographique à particules chargées pour déplacer un étage à l'intérieur de chaque chambre respective (400).

8. Agencement selon la revendication 6 ou la revendication 7, dans lequel chaque appareil lithographique est pourvu d'une unité de verrouillage de charge (303) sur sa paroi avant, et dans lequel l'unité de verrouillage de charge (303) est agencée au-dessus de l'actionneur d'étage (304) de chaque appareil lithographique respectif.

9. Agencement selon une quelconque des revendications précédentes, dans lequel le robot commun comprend au moins deux unités robotisées.

10. Agencement selon une quelconque des revendications précédentes, dans lequel l'agencement comprend en outre une unité de stockage de robot (307).

11. Agencement selon la revendication 10, dans lequel l'unité de stockage est agencée à une extrémité d'une rangée d'appareils lithographiques de façon adjacente à l'allée.

12. Agencement selon une quelconque des revendications précédentes, dans lequel un ou plusieurs des appareils lithographiques dans une rangée sont empilés verticalement, en deux, ou plus, couches.

13. Agencement selon la revendication 12, dans lequel chaque appareil lithographique est pourvu d'un support individuel à partir d'un plancher.

14. Agencement selon la revendication 12, dans lequel chaque couche d'appareils lithographiques est pourvue d'un support séparé par rapport à un plancher.

15. Agencement selon une quelconque des revendications précédentes, dans lequel une unité de traitement lithographique est agencée dans chaque chambre à vide (400).
